# EUROPÄISCHE PATENTSCHRIFT

(11) **EP 3 965 168 B1**
(45) Veröffentlichungstag und Bekanntmachung des Hinweises auf die Patenterteilung: **08.03.2023**
(21) Anmeldenummer: 20000322.6
(22) Anmeldetag: 07.09.2020
(51) Int. Cl.: H01L 31/0687, H01L 31/0304, H01L 31/054

(54) **STAPELFÖRMIGE MONOLITHISCHE MEHRFACHSOLARZELLE**
STACKED MONOLITHIC MULTI-JUNCTION SOLAR CELL
CELLULE SOLAIRE MULTIPLE MONOLITHIQUE EMPILÉE

(43) Veröffentlichungstag der Anmeldung: 09.03.2022
(73) Patentinhaber: AZUR SPACE Solar Power GmbH, 74072 Heilbronn (DE)
(72) Erfinder: Meusel, Matthias, 74076 Heilbronn (DE); Berg, Alexander, 74074 Heilbronn (DE); Guter, Wolfgang, 70190 Stuttgart (DE)
(74) Vertreter: Koch Müller Patentanwaltsgesellschaft mbH

(56) Entgegenhaltungen:
- CN-A- 107 871 799
- US-A1- 2020 027 999
- US-A1- 2020 251 603
- W. GUTER ET AL: "Space Solar Cells - 3G30 and Next Generation Radiation Hard Products", E3S WEB OF CONFERENCES, Bd. 16, 2017, Seiten 03005-1-03005-6, XP055464646, DOI: 10.1051/e3sconf/20171603005
- STEVEN WOJTCZUK ET AL: "Bifacial Growth InGaP/GaAs/InGaAs Concentrator Solar Cells", IEEE JOURNAL OF PHOTOVOLTAICS, I E E E, US, Bd. 2, Nr. 3, 3. April 2012 (2012-04-03), Seiten 371-376, XP011460263, ISSN: 2156-3381, DOI: 10.1109/JPHOTOV.2012.2189369
- TATAVARTI R ET AL: "InGaP/GaAs/InGaAs inverted metamorphic (IMM) solar cells on 4'' epitaxial lifted off (ELO) wafers", 35TH IEEE PHOTOVOLTAIC SPECIALISTS CONFERENCE (PVSC), 20-25 JUNE 2010, HONOLULU, HI, USA, IEEE, PISCATAWAY, NJ, USA, 20. Juni 2010 (2010-06-20), Seiten 2125-2128, XP031785491, ISBN: 978-1-4244-5890-5

## Beschreibung

Die Erfindung betrifft eine stapelförmige monolithische Mehrfachsolarzelle.

Eine stapelförmige monolithische Mehrfachsolarzelle ist beispielsweise aus der DE 10 2005 000 767 A1 bekannt. Die Mehrfachsolarzelle umfasst eine erste Germanium-Teilzelle sowie mindestens zwei weitere Teilzellen und mindestens einen Halbleiterspiegel, wobei der Halbleiterspiegel mehrere Schicht mit zumindest voneinander abweichenden Brechungsindizes sowie einen hohen Reflexionsgrad in zumindest einem Teil des Absorptionsbereichs des oder der darüber angeordneten Teilzellen sowie einen hohen Transmissionsgrad für Strahlung im spektralen Absorptionsbereich der unterhalb des Halbleiterspiegel angeordneten Teilzellen aufweist.

Aus der DE 10 2015 016 047 A1 ist eine stapelförmige monolithische III-V-Mehrfachsolarzelle mit einer ersten Germanium-Teilzelle und einer folgenden Indium und Phosphor aufweisenden zweiten Teilzelle. Weisen die erste und zweite Teilzelle unterschiedliche Gitterkonstanten auf, so umfasst die Mehrfachsolarzelle einen zwischen erster und zweiter Teilzelle angeordneten metamorphen Puffer.

Eine ähnliche Mehrfachsolarzelle ist aus der DE 10 2015 016 822 A1 bekannt.

Aus der EP 2 251 912 A1 ist eine stapelförmige metamorphe Mehrfachsolarzelle bekannt, wobei die zwischen den Teilzellen angeordneten Tunneldioden jeweils eine kompressiv verspannte erste Schicht und eine tensil verspannte zweite Schicht aufweisen, so dass jede Tunneldiode insgesamt spannungskompensiert ausgeführt ist.

Aus der US 2020/251603 A1, aus W.GUTER ET AL: "Space Solar Cells - 3G30 and Next Generation Radiation Hard Products", E3S Web OF CONFERENCES, Bd. 16, 2017, Seiten 03005-1-03005-6, der US 2020/027999 A1, der CN 107 871 799 A, aus STEVEN WOJTCZUK ET

AL: "Bifacial Growth InGaP/GaAs/InGaAs Concentrator Solar Cells", IEEE JOURNAL OF PHOTOVOLTAICS, I E E E, US, Bd. 2, Nr. 3, 3. April 2012, Seiten 371-376, aus TATAVARTI R ET AL: "InGaP/GaAs/InGaAs inverted metamorphic (IMM) solar cells on 4" epitaxial lifted off (ELO) wafers", 35TH IEEE PHOTOVOLTAIC SPECIALISTS CONFERENCE (PVSC), 20-25 JUNE 2010, HONOLULU, HI, USA, Seiten 2125-2128, sind weitere Mehrfachsolarzellen bekannt.

Vor diesem Hintergrund besteht die Aufgabe der Erfindung darin, eine Vorrichtung anzugeben, die den Stand der Technik weiterbildet.

Die Aufgabe wird durch eine stapelförmige monolithische Mehrfachsolarzelle mit den Merkmalen des Patentanspruchs 1 gelöst. Vorteilhafte Ausgestaltungen der Erfindung sind Gegenstand von Unteransprüchen.

Als Gegenstand der Erfindung wird eine stapelförmige monolithische Mehrfachsolarzelle bereitgestellt, aufweisend eine erste Teilzelle, eine zweite Teilzelle, eine dritte Teilzelle und mindestens eine vierte Teilzelle in der genannten Reihenfolge aufeinander folgend, wobei die Bandlücke beginnend von der ersten Teilzelle in Richtung zu der vierten Teilzelle von Teilzelle zu Teilzelle größer wird.

Jede Teilzelle weist einen n-dotierten Emitter und eine p-dotierte Basis auf, wobei der Emitter und die Basis der ersten Teilzelle jeweils Germanium aufweisen oder aus Germanium bestehen und alle auf die erste Teilzelle folgenden Teilzellen jeweils mindestens ein Element der III. Hauptgruppe des Periodensystems und ein Element der V. Hauptgruppe des Periodensystems aufweisen.

Zwischen jeweils zwei Teilzellen ist jeweils eine Tunneldiode mit einem p-n Übergang angeordnet.

Alle auf die erste Teilzelle folgenden Teilzellen sind zueinander gitterangepasst ausgebildet.

Zwischen der ersten Teilzelle und der folgenden zweiten Teilzelle ist ein Halbleiterspiegel aufweisend mehrere n-dotierte Halbleiterschichten mit alternierend unterschiedlichen Brechungsindizes angeordnet.

Zwischen der ersten Teilzelle und dem Halbleiterspiegel ist ein n-dotierter metamorpher Puffer angeordnet ist, wobei der metamorphe Puffer mindestens vier Stufen-Schichten und mindestens eine Überschussschicht aufweist.

Mindestens zwei der Schichten des metamorphen Puffers weisen eine Dotierung kleiner als 8•10¹⁷ cm⁻³ auf.

Es versteht sich, dass eine Tunneldiode zwischen zwei Teilzellen angeordnet ist.

Es sei angemerkt, dass die III-V-Teilzellen und weiteren Schichten der stapelförmigen Mehrfachsolarzelle auf der Ge-Unterzelle, z.B. einem Ge-Substrat, nacheinander epitaktisch gewachsen sind.

Des Weiteren sei angemerkt, dass mit dem Begriff der Überschussschicht eine Schicht des metamorphen Puffers, die eine größere Gitterkonstante als die Gitterkonstante der ersten Teilzelle und eine größere Gitterkonstante als die Gitterkonstante der zweiten Teilzelle bzw. der folgenden Teilzellen aufweist, bezeichnet ist.

Vorliegend handelt es sich um eine aufrecht gewachsene metamorphe Mehrfachsolarzelle, sogenannte UMM-Solarzellenanordnung, ohne Halbleiterbond oder Waferbond. Anders ausgedrückt, alle Teilzellen der Mehrfachzelle sind nacheinander epitaktisch in einer MOVPE Anlage aufeinander gewachsen und nicht aus zwei Teilstapel gefügt.

Die erste Teilzelle weist die kleinste Bandlücke und die vierte Teilzelle bei insgesamt vier Teilzellen die größte Bandlücke auf. Bei mehr als vier Teilzellen weist entsprechend die oberste Teilzelle die größte Bandlücke auf.

Vorzugsweise sind alle Teilzellen mit einer n-über-p-Struktur ausgebildet, weisen folglich einen n-dotiertem Emitter über einer p-dotierter Basis auf.

Überraschend ist, dass mit einer Reduzierung der Dotierung bei den Schichten eines n-dotierten metamorphen Puffers unter einen Wert von 1•10¹⁸ cm⁻³ der Wirkungsgrad der Mehrfachsolarzelle steigt.

Bisher ist man davon ausgegangen, dass es für die Leitfähigkeit vorteilhaft ist, die Dotierung der Pufferschichten in einem Bereich oberhalb von 1•10¹⁸ cm⁻³ zu wählen.

Des Weiteren ist üblicherweise der Halbleiterspiegel zur Erhöhung der Strahlungsstabilität einer Teilzelle bei gegebener Teilzellendicke direkt unterhalb der betreffenden Teilzelle d.h. unmittelbar unterhalb der p-dotierten Basis einer Teilzelle angeordnet und daher ebenfalls p-dotiert ausgeführt.

Es versteht sich, dass ein Halbleiterspiegel eine Vielzahl von Perioden aus dünnen Schichten aufweist, wobei die dünnen Schichten abwechselnd einen niedrigen und einen hohen Brechungsindex aufweisen.

Vorzugsweise umfasst eine Periode wenigstens zwei oder drei Schichten, wobei der Halbleiterspiegel wenigstens zehn Schichten, d.h. wenigstens 5 Perioden umfasst. In einer Weiterbildung umfasst der Halbleiterspiegel wenigstens 10 oder wenigstens 15 Perioden.

Im Unterschied hierzu wird eine Tunneldiode zwischen dem Halbleiterspiegel und der darüber folgenden Teilzelle, also der zweiten Teilzelle, angeordnet sodass der Halbleiterspiegel n-dotiert ausgebildet ist.

Überraschenderweise zeigte sich, dass bei Anordnung der Tunneldiode zwischen p-dotierter Basis und Halbleiterspiegel der Halbleiterspiegel bei unverändert gutem Reflexionsverhalten eine deutlich höhere Transmission in Bezug auf die darunterliegenden Teilzellen aufweist und sich der Wirkungsgrad der Mehrfachzelle erhöhen lässt.

Die Anordnung bestehend aus n-Dotierung der Schichten des Halbleiterspiegels in Verbindung mit einem niedrigen n-dotierten metamorphen Puffer führt zu einer Steigerung des Photostroms in der Ge Teilzelle.

Vorzugsweise weist der metamorphe Puffer mindestens drei Halbleiterschichten oder genau vier oder genau fünf oder genau sechs oder vorzugsweise sieben oder genau acht oder genau neun Schichten auf. Es versteht sich, dass die Überschussschichten als Teil des metamorphen Puffers ausgebildet sind.

Vorzugsweise weist der metamorphe Puffer eine sich graduell, z.B. stufenförmig oder rampenförmig von einem ersten Gitterkonstantenwert auf einen zweiten Gitterkonstantenwert ändernde Gitterkonstante auf.

In einer Weiterbildung weisen mindestens zwei der Schichten des metamorphen Puffers eine Dotierung kleiner als 5•10¹⁷ cm⁻³ oder kleiner als 3•10¹⁷ cm⁻³ oder kleiner als 1•10¹⁷ cm⁻³ oder kleiner als 7•10¹⁶ cm⁻³ oder kleiner als 4•10¹⁶ cm⁻³ auf.

Vorzugsweise umfassen oder bestehen die Halbleiterschichten des metamorphen Puffers üblicherweise aus InGaAs. In einer Ausführungsform weist oder besteht die Überschussschicht AlInGaAs auf, um die Transparenz für die darunterliegende Ge Zelle zu erhöhen.

Es sei angemerkt, dass sich die Stöchiometrie von Schicht zu Schicht des metamorphen Puffers ändert, um die Gitterkonstante von Schicht zu Schicht zu ändern. Vorzugsweise ändert sich die Konzentration von Indium von Schicht zu Schicht in einem Bereich zwischen 2% bis 5%.

in einer Ausführungsform unterscheiden sich die Schichten des metamorphen Puffers nicht mehr als einen Faktor zwei in der maximalen Höhe der Dotierungskonzentration.

In einer Weiterbildung umfasst der metamorphe Puffer eine zweite Überschussschicht.

In einer Ausführungsform weisen die Schichten des Halbleiterspiegels eine Dotierung kleiner als 1•10¹⁹ cm⁻³ oder kleiner als 5•10¹⁸ cm⁻³ oder kleiner als 3•10¹⁸ cm⁻³ oder kleiner als 1.5•10¹⁸ cm⁻³ oder kleiner als 8•10¹⁷ cm⁻³ oder kleiner als 5•10¹⁷ cm⁻³ auf.

In einer Ausführungsform weist der Halbleiterspiegel und die Schichten des metamorphen Pufferns Silizium oder Tellur als Dotierstoff auf.

In einer Weiterbildung weisen die Schichten des Halbleiterspiegels mit einem niedrigeren Brechungsindex eine niedrigere Dotierung und/oder einen unterschiedlichen Dotierstoff im Unterschied zu den Schichten des Halbleiterspiegels mit höherem Brechungsindex auf.

In einer Ausführungsform weisen die Schichten des Halbleiterspiegels mit einem niedrigeren Brechungsindex eine um mindestens einen Faktor 2 niedrigere Dotierung auf als Schichten des Halbleiterspiegels mit höherem Brechungsindex.

Vorzugsweise bestehen oder umfassen die Schichten des Halbleiterspiegels mit einem niedrigeren Brechungsindex AlInAs oder AlInAs. In einer Ausführungsform weisen die Schichten des Halbleiterspiegels mit einem niedrigeren Brechungsindex kein Gallium auf.

In einer Weiterbildung weisen die Schichten des Halbleiterspiegels eine Dotierung größer als 5•10¹⁶ cm⁻³ oder größer als 1•10¹⁷ cm⁻³ oder größer als 5•10¹⁷ cm⁻³ auf.

In einer Ausführungsform weisen mindestens zwei der Schichten des metamorphen Puffers oder alle Schichten des metamorphen Puffers eine Dotierung kleiner als die Dotierung der Schichten des Halbleiterspiegels auf.

In einer anderen Weiterbildung weist die Mehrfachsolarzelle eine fünfte Teilzelle auf.

In einer anderen Ausführungsform weist die zweite Teilzelle InGaAs auf oder besteht aus InGaAs.

Alternativ oder ergänzend weist die dritte Tellzelle GaAs oder AlInGaAs oder InGaAsP auf oder besteht aus GaAs oder aus AlInGaAs oder InGaAsP.

In einer Ausführungsform weist die vierte Teilzelle AlInGaP oder InAlP auf oder besteht aus AlInGaP oder aus oder InAlP.

Mit dem Begriff "aufweist" wird ausgedrückt, dass die entsprechende Teilzelle neben dem genannten Material auch weitere Materialien, in Ausführungsformen insbesondere weitere Elemente der III. und/oder V. Hauptgruppe aufweist. Im Unterschied hierzu drückt der Begriff "bestehen aus" aus, dass die Solarzelle im Wesentlichen aus dem genannten Materialien besteht und insbesondere keine weiteren Elemente der III. und/oder V. Hauptgruppe aufweist.

Es versteht sich, dass jede Solarzelle neben den genannten Materialien zusätzlich Dotierstoffe, z.B. Tellur oder Silizium, und gegebenenfalls auch Verunreinigungen aufweist.

In einer Weiterbildung weist die Mehrfachsolarzelle eine fünfte Teilzelle auf, wobei die fünfte Teilzelle zwischen der vierten Teilzelle und der dritten Teilzelle angeordnet ist und InGaP aufweist oder aus InGaP besteht. In einer Weiterbildung ist die fünfte Teilzelle auf der vierten Teilzelle ausgebildet.

In einer Weiterbildung weist die Mehrfachsolarzelle genau vier Teilzellen auf, wobei die vierte Teilzelle eine Bandlücke zwischen 2,0 eV und 1,8 eV aufweist und die die dritte Teilzelle eine Bandlücke zwischen 1,4 eV und 1,6 eV aufweist und die zweite Teilzelle eine Bandlücke zwischen 1 eV und 1,2 eV aufweist und die erste Teilzelle eine Bandlücke zwischen 0,6 eV und 0,7 eV aufweist.

Alternativ sind eine oder mehrere der Teilzellen als Hetero-Teilzellen ausgebildet. Hierbei weisen der Emitter und die Basis eine unterschiedliche Komposition an Elementen auf. Es versteht sich jedoch, dass die Gitterkonstanten von Emitter und Basis bei den jeweiligen Teilzellen gleich sind.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und vertikale Erstreckung sind nicht maßstäblich und weisen, sofern nicht anders angegeben, auch keine ableitbaren geometrischen Relationen zueinander auf. Darin zeigen, die
- Figur 1: eine Ansicht einer ersten Ausführungsform einer stapelförmigen monolithischen Mehrfachsolarzelle,
- Figur 2: eine Ansicht einer zweiten Ausführungsform,

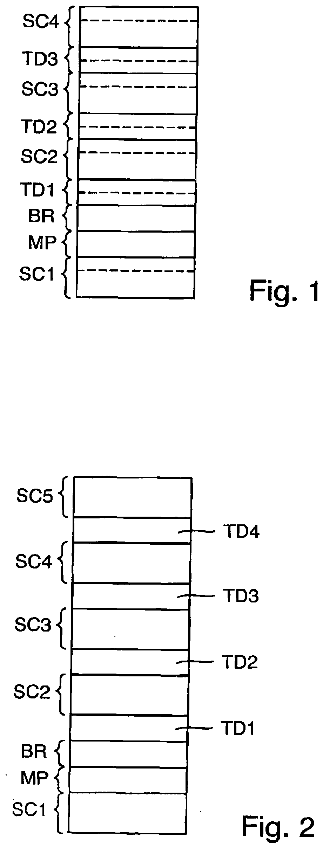

Die Abbildung der Figur 1 zeigt einen schematischen Querschnitt durch eine Mehrfachsolarzelle mit vier stapelförmig angeordneten monolithischen Teilzellen SC1, SC2, SC3 und SC4.

Jede Teilzelle weist eine p-dotierte Basis und einen n-dotierten Emitter auf, wobei Emitter und Basis der ersten Teilzelle SC1 Germanium aufweisen oder aus Germanium bestehen und Emitter sowie Basis der auf die erste Teilzelle SC1 folgenden Teilzellen SC2, SC3 und SC4 jeweils mindestens ein Element der III. Hauptgruppe und mindestens ein Element der V. Hauptgruppe aufweisen.

Jede der weiteren Teilzellen SC2, SC3 und SC4 ist entweder als Homo-Teilzellen oder als Hetero-Teilzelle ausgebildet.

Die Teilzellen SC1, SC2, SC3 und SC4 weisen von der ersten Teilzelle SC1 in Richtung der vierten Teilzelle SC4 von Teilzelle zu Teilzelle zunehmende Bandlücken auf.

Die zweite, dritte und vierte Teilzelle SC2, SC3 und SC4 sind zueinander gitterangepasst ausgeführt, während die erste Teilzelle SC1 eine sich von der Gitterkonstanten der weiteren Teilzellen SC2, SC3 und SC4 unterscheidende Gitterkonstante aufweist.

Um den Unterschied in der Gitterkonstante auszugleichen, weist die stapelförmige Mehrfachsolarzelle zusätzlich einen metamorphen Puffer MP mit sich entlang einer Höhe des metamorphen Puffers MP ändernden Gitterkonstanten auf.

Der metamorphe Puffer MP ist zwischen einer Oberseite der ersten Teilzelle SC1 und einer Unterseite des Halbleiterspiegels BR angeordnet und n-dotiert. Die Gitterkonstante des metamorphen Puffers MP ändert sich beispielsweise entlang der Höhe rampen- oder stufenförmig von einem der Gitterkonstanten der ersten Teilzelle SC1 entsprechenden Wert bis zu einem der Gitterkonstanten der zweiten Teilzelle SC2 entsprechenden Wert und weist eine Überschussschicht auf, so dass die Gitterkonstante von Schicht zu Schicht erst zu und dann wieder auf den Wert der Gitterkonstante der zweiten Teilzelle SC2 abnimmt.

Der metamorphe Puffer MP ist n-dotiert und umfasst mindestens vier Stufen-Schichten und mindestens eine Überschussschicht. Mindestens zwei der Schichten des metamorphen Puffers weisen eine Dotierung kleiner als 8•10¹⁷ cm⁻³ auf.

Vorzugsweise ist der Unterschied in der Dotierung der Schichten des metamorphen Puffers zueinander kleiner als ein Faktor 2.

Auf einer Oberseite der ersten Teilzelle SC1 ist ein an den Emitter der ersten Teilzelle SC1 angrenzender Halbleiterspiegel BR angeordnet. Der Halbleiterspiegel BR weist mehrere n-dotierte Halbleiterschichten mit alternierend unterschiedlichen Brechungsindizes und einer Dotierstoffkonzentration von jeweils höchstens 1•10¹⁹ cm⁻³ oder höchstens 5•10¹⁸ cm⁻³ auf.

Auf einer Oberseite des Halbleiterspiegels BR und an die Basis der zweiten Teilzelle SC2 angrenzend ist eine erste Tunneldiode TD1 mit einer an den Halbleiterspiegel angrenzenden n-dotierten und einer an die zweite Teilzelle SC2 angrenzenden p-dotierten Schicht angeordnet.

Eine zweite Tunneldiode TD2 ist zwischen der zweiten Teilzelle SC2 und der dritten Teilzelle SC3 und eine dritte Tunneldiode TD3 zwischen der dritten Teilzelle SC3 und der vierten Teilzelle SC4 angeordnet, wobei jede Tunneldiode TD1, TD2 sowie TD3 jeweils einen p-n Übergang, also eine n-dotierte und eine p-dotierte Schicht aufweist.

In der Abbildung der Figur 2 ist eine weitere Ausführungsform dargestellt. Im Folgenden werden nur die Unterschiede zu der Abbildung der Figur 1 erläutert.

Die Mehrfachsolarzelle ist als metamorphe Fünffach-Solarzelle ausgebildet, wobei die zweite, dritte, vierte und fünfte Teilzelle SC2, SC3, SC4 und SC5 zueinander gitterangepasst ausgeführt sind, wobei die erste Teilzelle SC1 eine von der Gitterkonstante der folgenden Teilzellen SC2, SC3, SC4 und SC5 abweichende Gitterkonstante aufweist.

Der Unterschied der Gitterkonstanten wird mittels eines zwischen der ersten Teilzelle SC1 und dem Halbleiterspiegel BR angeordneten metamorphen Puffers MP ausgeglichen.

In einer nicht dargestellten Ausführungsform ist die fünfte Teilzelle zwischen der vierten Teilzelle und der dritten Teilzelle angeordnet und weist InGaP auf oder besteht aus InGaP.

## Patentansprüche

1. Stapelförmige monolithische Mehrfachsolarzelle, aufweisend eine erste Teilzelle (SC1), eine zweite Teilzelle (SC2), eine dritte Teilzelle (SC3) und mindestens eine vierte Teilzelle (SC4) in der genannten Reihenfolge aufeinander folgend, wobei
- die Bandlücke beginnend von der ersten Teilzelle (SC1) in Richtung zu der vierten Teilzelle (SC4) von Teilzelle zu Teilzelle größer wird,
- jede Teilzelle (SC1, SC2, SC3, SC4) einen n-dotierten Emitter und eine p-dotierte Basis aufweist,
- der Emitter und die Basis der ersten Teilzelle (SC1) jeweils Germanium aufweisen oder aus Germanium bestehen,
- alle auf die erste Teilzelle (SC1) folgenden Teilzellen (SC2, SC3, SC4) jeweils mindestens ein Element der III. und der V. Hauptgruppe des Periodensystems aufweisen,
- zwischen jeweils zwei Teilzellen (SC1, SC2, SC3, SC4) jeweils eine Tunneldiode (TD1, TD2, TD3) mit einem p-n Übergang angeordnet ist,
- alle auf die erste Teilzelle (SC1) folgenden Teilzellen (SC2, SC3, SC4) zueinander gitterangepasst ausgebildet sind,
- zwischen der ersten Teilzelle (SC1) und der folgenden zweiten Teilzelle (SC2) ein n-dotierter Halbleiterspiegel (BR) aufweisend mehrere dotierte Halbleiterschichten mit alternierend unterschiedlichen Brechungsindizes angeordnet ist, und
zwischen der ersten Teilzelle (SC1) und dem Halbleiterspiegel (BR) ein n-dotierter metamorpher Puffer (MP) angeordnet ist, **dadurch gekennzeichnet, dass** der metamorphe Puffer mindestens vier Stufen-Schichten und mindestens eine Überschussschicht aufweist,
und die Dotierung der Schichten des n-dotierten metamorphen Puffers unter einen Wert von 1•10¹⁸ cm⁻³ liegt, und
mindestens zwei der Schichten des metamorphen Puffers eine Dotierung kleiner als 8•10¹⁷ cm⁻³ aufweisen,
zwischen der zweiten Teilzelle (SC2) und dem Halbleiterspiegel (BR) eine Tunneldiode (TD1) angeordnet ist, so dass sich auf der ersten Teilzelle (SC1), der metamorphe Puffer (MP), der Halbleiterspiegel (BR), die Tunneldiode (TD1) und die zweite Teilzelle (SC2) in der genannten Reihenfolge ausgebildet sind.

2. Mehrfachsolarzelle nach Anspruch 1, **dadurch gekennzeichnet, dass** mindestens zwei der Schichten des metamorphen Puffers eine Dotierung kleiner als 5•10¹⁷ cm⁻³ oder kleiner als 3•10¹⁷ cm⁻³ oder kleiner als 1•10¹⁷ cm⁻³ oder kleiner als 7•10¹⁶ cm⁻³ oder kleiner als 4•10¹⁶ cm⁻³ aufweisen.

3. Mehrfachsolarzelle nach einem der vorstehenden Ansprüche, **dadurch gekennzeichnet, dass** alle Schichten des metamorphen Puffers sich bezüglich ihrer Dotierung um nicht mehr als einen Faktor 2 unterscheiden.

4. Mehrfachsolarzelle nach einem der vorstehenden Ansprüche, **dadurch gekennzeichnet, dass** der metamorphe Puffer mindestens zwei Überschussschichten aufweist.

5. Mehrfachsolarzelle nach einem der vorstehenden Ansprüche, **dadurch gekennzeichnet, dass** die Schichten des Halbleiterspiegels (BR) eine Dotierung kleiner als 1•10¹⁹ cm⁻³ oder kleiner als 5•10¹⁸ cm⁻³ oder kleiner als 3•10¹⁸ cm⁻³ oder kleiner als 1.5•10¹⁸ cm⁻³ oder kleiner als 8•10¹⁷ cm⁻³ aufweist.

6. Mehrfachsolarzelle nach einem der vorstehenden Ansprüche, **dadurch gekennzeichnet, dass** der Halbleiterspiegel (BR) und der metamorphe Puffer Silizium oder Tellur als Dotierstoff aufweisen.

7. Mehrfachsolarzelle nach einem der vorstehenden Ansprüche, **dadurch gekennzeichnet, dass** die Schichten des Halbleiterspiegels (BR) mit einem niedrigeren Brechungsindex eine niedrigere Dotierung und/oder einen unterschiedlichen Dotierstoff aufweisen als Schichten des Halbleiterspiegels mit höherem Brechungsindex.

8. Mehrfachsolarzelle nach einem der vorstehenden Ansprüche, **dadurch gekennzeichnet, dass** die Schichten des Halbleiterspiegels (BR) mit einem niedrigeren Brechungsindex eine um mindestens einen Faktor 2 niedrigere Dotierung aufweisen als Schichten des Halbleiterspiegels mit höherem Brechungsindex.

9. Mehrfachsolarzelle nach einem der vorstehenden Ansprüche, **dadurch gekennzeichnet, dass** die Schichten des Halbleiterspiegels (BR) mit einem niedrigeren Brechungsindex AlInAs aufweist oder aus AlInAs besteht oder kein Gallium aufweisen.

10. Mehrfachsolarzelle nach einem der vorstehenden Ansprüche, **dadurch gekennzeichnet, dass** die Schichten des Halbleiterspiegels (BR) eine Dotierung größer als 5•10¹⁶ cm⁻³ oder größer als 1•10¹⁷ cm⁻³ oder größer als 5•10¹⁷ cm⁻³ aufweist.

11. Mehrfachsolarzelle nach einem der vorstehenden Ansprüche, **dadurch gekennzeichnet, dass** mindestens zwei der Schichten des metamorphen Puffers eine Dotierung kleiner als die Dotierung der Schichten des Halbleiterspiegels (BR) aufweisen.

12. Mehrfachsolarzelle nach einem der vorstehenden Ansprüche, **dadurch gekennzeichnet, dass** genau vier Teilzellen vorgesehen sind, wobei die vierte Teilzelle eine Bandlücke zwischen 2,0 eV und 1,8 eV aufweist und die die dritte Teilzelle eine Bandlücke zwischen 1,4 eV und 1,6 eV aufweist und die zweite Teilzelle eine Bandlücke zwischen 1 eV und 1,2 eV aufweist und die erste Teilzelle eine Bandlücke zwischen 0,6 eV und 0,7 eV aufweist.

13. Mehrfachsolarzelle nach einem der Ansprüche 1 bis 11, **dadurch gekennzeichnet, dass** die Mehrfachsolarzelle eine fünfte Teilzelle (SC5) aufweist.

## Claims

1. Stacked monolithic multi-junction solar cell comprising a first subcell (SC1), a second subcell (SC2), a third subcell (SC3) and at least one fourth subcell (SC4) in the stated sequence following one another, wherein
- the band gap beginning from the first subcell (SC1) is larger from subcell to subcell in direction towards the fourth subcell (SC4),
- each subcell (SC1, SC2, SC3, SC4) comprises an n-doped emitter and a p-doped base,
- the emitter and the base of the first subcell (SC1) each comprise germanium or consist of germanium,
- all subcells (SC2, SC3, SC4) following the first subcell (SC1) each comprise an element of the III and V main group of the periodic system,
- a respective tunnel diode (TD1, TD2, TD3) with a p-n transition is arranged between each two subcells (SC1, SC2, SC3, SC4),
- all subcells (SC2, SC3, SC4) following the first subcell (SC1) are constructed to be lattice-matched to one another,
- an n-doped semiconductor mirror (BR) comprising several doped semiconductor layers with refraction indices differing in alternation is arranged between the first subcell (SC1) and the following second subcell (SC2), and
an n-doped metamorphic buffer (MP) is arranged between the first subcell (SC1) and the semiconductor mirror (BR),
**characterised in that**
the metamorphic buffer comprises at least four step layers and at least one overshoot layer, and
the doping of the layers of the n-doped metamorphic buffer lies below a value of 1 • 10¹⁸ cm⁻³, and
at least two of the layers of the metamorphic buffer have a doping less than 8 •10¹⁷ cm⁻³, a tunnel diode (TD1) is arranged between the second subcell (SC2) and the semiconductor mirror (BR) so that the metamorphic buffer (MP), the semiconductor mirror (BR), the tunnel diode (TD1) and the second subcell (SC2) follow on the first subcell (SC1) in the stated sequence.

2. Multi-junction solar cell according to claim 1, **characterised in that** at least two of the layers of the metamorphic buffer have a doping less than 5 • 10¹⁷ cm⁻³ or less than 3 • 10¹⁷ cm⁻³ or less than 1 • 10¹⁷ cm⁻³ or less than 7 • 10¹⁶ cm⁻³ or less than 4 • 10¹⁶ cm⁻³.

3. Multi-junction solar cell according to either one of the preceding claims, **characterised in that** all layers of the metamorphic buffer differ by more than a factor 2 with respect to their doping.

4. Stacked monolithic multi-junction solar cell according to any one of the preceding claims, **characterised in that** the metamorphic buffer has at least two overshoot layers.

5. Multi-junction solar cell according to any one of the preceding claims, **characterised in that** the layers of the semiconductor mirror (BR) have a doping less than 1 • 10¹⁹ cm⁻³ or less than 5 • 10¹⁸ cm⁻³ or less than 3 • 10¹⁸ cm⁻³ or less than 1.5 • 10¹⁸ cm⁻³ or less than a • 10¹⁷ cm⁻³,

6. Multi-junction solar cell according to any one of the preceding claims, **characterised in that** the semiconductor mirror (BR) and the metamorphic buffer comprise silicon or tellurium as doping substance.

7. Multi-junction solar cell according to any one of the preceding claims, **characterised in that** the layers of the semiconductor mirror (BR) with a lower index of infraction have a lower doping and/or a different doping substance than layers of the semiconductor mirror with a higher index of refraction.

8. Multi-junction solar cell according any one of the preceding claims, **characterised in that** the layers of the semiconductor mirror (BR) with a lower index of infraction have a doping lower by at least a factor 2 than layers of the semiconductor mirror with a higher index of refraction.

9. Multi-junction solar cell according to any one of the preceding claims, **characterised in that** the layers of the semiconductor mirror (BR) with a lower index of infraction comprise AlInAs or consist of AlInAs or do not comprise gallium.

10. Multi-junction solar cell according to any one of the preceding claims, **characterised in that** the layers of the semiconductor mirror (BR) have a doping greater than 5 • 10¹⁶ cm⁻³ or greater than 1 • 10¹⁷ cm⁻³ or greater than 5 • 10¹⁷ cm⁻³.

11. Multi-junction solar cell according to any one of the preceding claims, **characterised in that** at least two of the layers of the metamorphic buffer have a doping lower than the doping of the layers of the semiconductor mirror (BR).

12. Multi-junction solar cell according to any one of the preceding claims, **characterised in that** exactly four subcells are provided, wherein the fourth subcell has a band gap between 2.0 eV and 1.8 eV and the third subcell has a band gap between 1.4 eV and 1.6 eV and the second subcell has a band gap between 1 eV and 1.2 eV and the first subcell has a band gap between 0.6 eV and 0.7 eV.

13. Multi-junction solar cell according to any one of claims 1 to 11, **characterised in that** the multi-junction solar cell comprises a fifth subcell (SC5).

## Revendications

1. Cellule solaire à jonctions multiples monolithique en forme de pile, comprenant une première sous-cellule (SC1), une deuxième sous-cellule (SC2), une troisième sous-cellule (SC3) et au moins une quatrième sous-cellule (SC4) se suivant dans l'ordre indiqué, dans laquelle
- la bande interdite s'accroit de sous-cellule en sous-cellule à partir de la première sous-cellule (SC1) en direction de la quatrième sous-cellule (SC4),
- chaque sous-cellule (SC1, SC2, SC3, SC4) comporte un émetteur dopé n et une base dopée p,
- l'émetteur et la base de la première sous-cellule (SC1) comportent chacun du germanium ou sont constitués de germanium,
- toutes les sous-cellules (SC2, SC3, SC4) suivant la première sous-cellule (SC1) comportent chacune au moins un élément du groupe III et du groupe V du système périodique,
- entre chaque paire de sous-cellules (SC1, SC2, SC3, SC4) est disposée une diode tunnel (TD1, TD2, TD3) avec une jonction p-n,
- toutes les sous-cellules (SC2, SC3, SC4) suivant la première sous-cellule (SC1) sont appariées entre elles en termes de réseau,
- entre la première sous-cellule (SC1) et la deuxième sous-cellule (SC2) qui la suit est agencé un miroir semi-conducteur dopé n (BR) comportant plusieurs couches semi-conductrices dopées avec des indices de réfraction variant alternativement et
un tampon métamorphique dopé n (MP) est agencé entre la première sous-cellule (SC1) et le miroir semi-conducteur (BR), **caractérisée en ce que** le tampon métamorphique comporte au moins quatre couches de niveau et au moins une couche excédentaire
et le dopage des couches du tampon métamorphique dopé n est inférieur à une valeur de 1•10¹⁸ cm⁻³,
au moins deux des couches du tampon métamorphique présentent un dopage inférieur à 8•10¹⁷ cm⁻³ et
entre la deuxième sous-cellule (SC2) et le miroir semi-conducteur (BR) est agencée une diode tunnel (TD1) de sorte que le tampon métamorphique (MP), le miroir semi-conducteur (BR), la diode tunnel (TD1) et la deuxième cellule partielle (SC2) sont formés dans l'ordre indiqué sur la première cellule partielle (SC1).

2. Cellule solaire à jonctions multiples selon la revendication 1, **caractérisée en ce qu'**au moins deux des couches du tampon métamorphique présentent un dopage inférieur à 5•10¹⁷ cm⁻³ ou inférieur à 3•10¹⁷ cm⁻³ ou inférieur à 1•10¹⁷ cm⁻³ ou inférieur à 7•10¹⁶ cm⁻³ ou inférieur à 4•10¹⁶ cm⁻³.

3. Cellule solaire à jonctions multiples selon une des revendications précédentes, **caractérisée en ce que** toutes les couches du tampon métamorphique ne se différencient pas d'un facteur supérieur à 2 en ce qui concerne leur dopage.

4. Cellule solaire à jonctions multiples selon une des revendications précédentes, **caractérisée en ce que** le tampon métamorphique comprend au moins deux couches excédentaires.

5. Cellule solaire à jonctions multiples selon une des revendications précédentes, **caractérisée en ce que** les couches du miroir semi-conducteur (BR) présentent un dopage inférieur à 1•10¹⁹ cm⁻³ ou inférieur à 5•10¹⁸ cm⁻³ ou inférieur à 3•10¹⁸ cm⁻³ ou inférieur à 1,5•10¹⁸ cm⁻³ ou inférieur à 8•10¹⁷ cm⁻³.

6. Cellule solaire à jonctions multiples selon une des revendications précédentes, **caractérisée en ce que** le miroir semi-conducteur (BR) et le tampon métamorphique comportent du silicium ou du tellure comme agent de dopage.

7. Cellule solaire à jonctions multiples selon une des revendications précédentes, **caractérisée en ce que** les couches du miroir semi-conducteur (BR) ayant un indice de réfraction plus faible présentent un dopage plus faible et/ou un agent de dopage différent des couches du miroir semi-conducteur ayant un indice de réfraction plus élevé.

8. Cellule solaire à jonctions multiples selon une des revendications précédentes, **caractérisée en ce que** les couches du miroir semi-conducteur (BR) ayant un indice de réfraction plus faible présentent un dopage plus faible d'au moins un facteur 2 que les couches du miroir semi-conducteur ayant un indice de réfraction plus élevé.

9. Cellule solaire à jonctions multiples selon une des revendications précédentes, **caractérisée en ce que** les couches du miroir semi-conducteur (BR) ayant un indice de réfraction plus faible comportent de l'AlInAs ou sont constituées d'AlInAs ou ne comportent pas de gallium.

10. Cellule solaire à jonctions multiples selon une des revendications précédentes, **caractérisée en ce que** les couches du miroir semi-conducteur (BR) présentent un dopage supérieur à 5•10¹⁶ cm⁻³ ou supérieur à 1•10¹⁷ cm⁻³ ou supérieur à 5•10¹⁷ cm⁻³.

11. Cellule solaire à jonctions multiples selon une des revendications précédentes, **caractérisée en ce qu'**au moins deux des couches du tampon métamorphique présentent un dopage inférieur au dopage des couches du miroir semi-conducteur (BR).

12. Cellule solaire à jonctions multiples selon une des revendications précédentes, **caractérisée en ce qu'**il est prévu exactement quatre sous-cellules, dans laquelle la quatrième sous-cellule présente une bande interdite située entre 2,0 eV et 1,8 eV et la troisième sous-cellule présente une bande interdite située entre 1,4 eV et 1,6 eV et la deuxième sous-cellule présente une bande interdite située entre 1 eV et 1,2 eV et la première sous-cellule présente une bande interdite située entre 0,6 eV et 0,7 eV.

13. Cellule solaire à jonctions multiples selon une des revendications 1 à 11, **caractérisée en ce que** cette cellule solaire à jonctions multiples comporte une cinquième sous-cellule (SCS).
